# EUROPEAN PATENT APPLICATION

(11) **EP 2 068 355 A1**
(43) Date of publication of application: **10.06.2009**
(21) Application number: 06810864.6
(22) Date of filing: 29.09.2006
(51) Int. Cl.: H01L 21/338, H01L 29/778, H01L 29/78, H01L 29/812

(54) **COMPOUND SEMICONDUCTOR DEVICE AND PROCESS FOR PRODUCING THE SAME**

(71) Applicant: Fujitsu Limited, Kawasaki-shi, Kanagawa 211-8588 (JP)
(72) Inventor: KANAMURA, Masahito, Kawasaki-shi, Kanagawa 2118588 (JP)
(74) Representative: Holtby, Christopher Lawrence
(86) International application number: PCT/JP2006/319466
(87) International publication number: WO 2008/041277

(57) **Abstract**

A compound semiconductor device including an electron transport layer (12) that is formed on a substrate and includes a III-V nitride compound semiconductor, a gate insulating film (17) that is positioned above the compound semiconductor layer, and a gate electrode (18) that is positioned on the gate insulating film. The gate insulating film includes a first insulating film (15, 26) that includes oxygen, at least a single metal element selected from a metal bonding with the oxygen and forming a metal oxide having a dielectric constant no less than 10, and at least a single metal element selected from Si and Al.

## Description

### TECHNICAL FIELD

The present invention relates to a compound semiconductor device, and more specifically, to an insulted gate structure of a GaN field effect transistor (FET) and a manufacturing method thereof.

### BACKGROUND ART

In recent years, there is active development of GaN-FET using AlGaN/GaN heterojunction and having gallium nitride (GaN) as an electron transport layer. GaN is a material having wide band gap, high breakdown field strength, and large saturation electron velocity and is highly anticipated as a material with high voltage performance and high output. Currently, in power devices for mobile phone base stations, a high voltage performance no less than 40 V is desired for achieving high transmission output power. GaN-FET is anticipated as a power device capable of such voltage resistant performance.

As a high voltage performance device, reduction of gate leak is a requisite. Currently, a Schottky electrode such as nickel (Ni), and platinum (Pt) is used as a GaN-FET gate electrode. However, with this configuration, gate leak current may be generated in a case where gate voltage is increased in a positive direction.

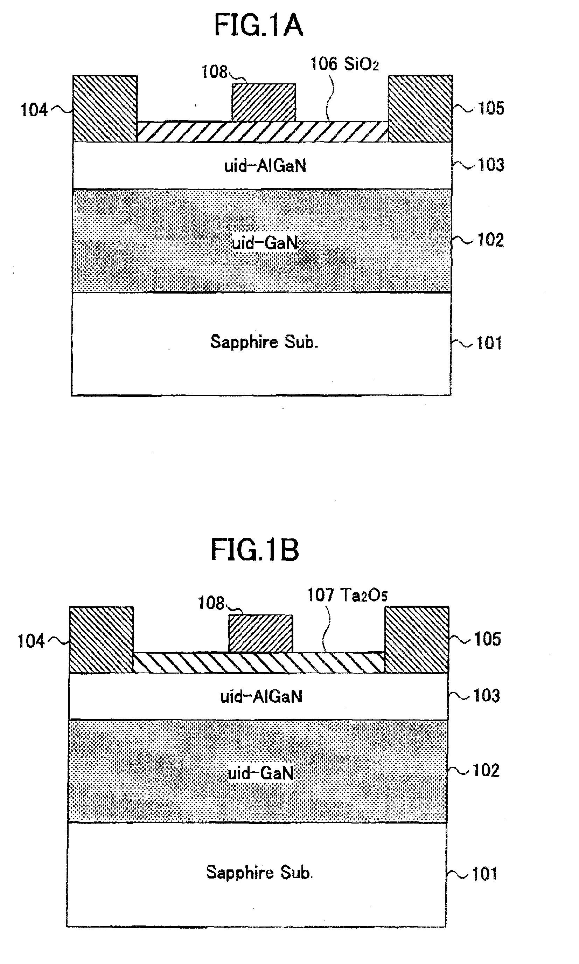

As illustrated in Fig. 1A, an insulating gate structure using an insulating film (e.g., SiO₂, Si₃N₄, Al₂O₃) as a gate may be considered for solving this. In the example illustrated in Fig. 1A, an unintentionally doped (or non-intentionally doped) GaN electron transport layer (uid-GaN) 102 having a film thickness of 3 µm and an unintentionally doped Al_{0.25}Ga_{0.75}N layer 103 having a film thickness of 20 nm are deposited in this order on a sapphire substrate 101 by using a regular MOVPE method. After forming a source electrode 104 and a drain electrode 105 using, for example, Ti/Al, a SiO₂ film 106 is deposited. By forming a gate electrode 108 on top of that by using a lift-off method, an insulted gate FET is completed.

However, because the dielectric constant of SiO₂, Si₃N₄, and AlO₃ is relatively small, problems such as a threshold shifting toward a negative direction or reduction of transconductance may occur and degrade amplification performance of an amplifier.

Accordingly, as illustrated in Fig. 1B, an oxide of metal (e.g., Ta, Hf, Zr) 107 such as Ta₂O₅ may be used as a gate. This is because an oxide such as Ta₂O₅ and HfO₂ has a relatively high dielectric constant.

A configuration having a rare earth oxide layer with a X₂O₃ structure inserted between a III-V compound semiconductor substrate and a gate electrode is known as a configuration of the insulated gate for reducing leak current (see, for example, Patent Document 1). In a field effect transistor using a high-k material, a configuration having a metal nitride or a metal nitride oxide inserted between a high-k gate dielectric film and a poly-silicon gate electrode is known as a configuration of an intermediate insulating film for preventing shifting of a threshold voltage and a flat band voltage (see, for example, Patent Document 2).
Patent Document 1: Japanese Laid-Open Publication No. 2000-150503
Patent Document 2: Japanese Laid-Open Publication No. 2005-328059

### DISCLOSURE OF INVENTION

### PROBLEM TO BE SOLVED BY INVENTION

However, due to having a gap narrower than that of SiO₂ or Al₂O₃, there is concern that the high dielectric metal oxide is insufficient from an aspect of voltage resistance (also referred to as "breakdown voltage"). Thus, it is difficult to attain both high voltage resistance and high dielectric constant.

Accordingly, the present invention aims to provide an insulating gate structure capable of attaining both high voltage resistance and high dielectric constant and a manufacturing method thereof.

### MEANS FOR SOLVING PROBLEM

In order to solve the above-described problem, a configuration, which includes oxygen, at least a single metal element selected from a metal bonding with the oxygen and forming a metal oxide having a dielectric constant no less than 10, and at least a single second metal element selected from Si and Al, is used as an insulating gate structure.

More specifically, according to a first aspect, a compound semiconductor device includes
(a) an electron transport layer that is formed on a substrate and includes a III-V nitride compound semiconductor,
(b) a gate insulating film that is positioned above the compound semiconductor layer, and (c) a gate electrode that is positioned on the gate insulating film, the gate insulating film including a first insulating film that includes oxygen, at least a single metal element selected from a metal bonding with the oxygen and forming a metal oxide having a dielectric constant no less than 10, and at least a single metal element selected from Si and Al.

In a preferable exemplary configuration, the gate insulating film further includes a second insulating film that is positioned on the first insulating film and includes a metal oxide having a dielectric constant no less than 10.

For example, the electron transport layer is a GaN layer. This case further includes a AlₓGa₁₋ₓ N (0 ≦ x ≦ 1) electron supplying layer that is provided on the electron transport layer, the AlₓGa₁₋ₓ N (0 ≦ x ≦ 1) electron supplying layer doped with impurities having a predetermined density, and a doped GaN layer that is provided between the AlₓGa₁₋ₓ N (0 ≦ x ≦ 1) electron supplying layer and the gate insulating film, the doped GaN layer doped with impurities having a predetermined density.

According to a second aspect, there is provided a manufacturing method of a compound semiconductor device. The method includes the steps of:
(a) forming an electron transport layer including a III-V nitride compound semiconductor on a substrate,
(b) forming a first insulating film including oxygen, at least a single metal element selected from a metal bonding with the oxygen and forming a metal oxide having a dielectric constant no less than 10, and at least a single metal element selected from Si and Al, above the electron transport layer; and
(c) forming a gate electrode above the first insulating film.

In a preferable example, the first insulating film is formed by depositing a silicon film on the electron transport layer, forming a layer of a metal oxide having a dielectric constant no less than 10, on the silicon film, and annealing the silicon film and the layer of the metal oxide.

This case changes at least a portion of the silicon film into the first insulating film by the annealing step.

### EFFECT OF THE INVENTION

According to the above-described configuration and method, both high voltage resistance and high dielectric constant can be attained with an insulating gate structure of a compound semiconductor device.

### BRIEF DESCRIPTION OF THE DRAWINGS

Fig. 1A is a diagram illustrating an exemplary configuration considered to solve a problem;
Fig. 1B is a diagram illustrating an exemplary configuration considered to solve a problem;
Fig. 2 is a schematic cross-sectional view of a compound semiconductor device according to an embodiment of the present invention;
Fig. 3A is a diagram illustrating a manufacturing step of a compound semiconductor device according to a first embodiment of the present invention;
Fig. 3B is a diagram illustrating a manufacturing step of a compound semiconductor device according to a first embodiment of the present invention;
Fig.3C is a diagram illustrating a manufacturing step of a compound semiconductor device according to a first embodiment of the present invention;
Fig. 3D is a diagram illustrating a manufacturing step of a compound semiconductor device according to a first embodiment of the present invention;
Fig. 3E is a diagram illustrating a manufacturing step of a compound semiconductor device according to a first embodiment of the present invention;
Fig. 3F is a diagram illustrating a manufacturing step of a compound semiconductor device according to a first embodiment of the present invention;
Fig. 4A is a diagram illustrating a manufacturing step of a compound semiconductor device according to a second embodiment of the present invention;
Fig. 4B is a diagram illustrating a manufacturing step of a compound semiconductor device according to a second embodiment of the present invention;
Fig. 4C is a diagram illustrating a manufacturing step of a compound semiconductor device according to a second embodiment of the present invention;
Fig. 4D is a diagram illustrating a manufacturing step of a compound semiconductor device according to a second embodiment of the present invention;
Fig. 4E is a diagram illustrating a manufacturing step of a compound semiconductor device according to a second embodiment of the present invention;
Fig. 5A is a diagram illustrating a manufacturing step of a compound semiconductor device according to a third embodiment of the present invention;
Fig. 5B is a diagram illustrating a manufacturing step of a compound semiconductor device according to a third embodiment of the present invention;
Fig. 5C is a diagram illustrating a manufacturing step of a compound semiconductor device according to a third embodiment of the present invention;
Fig. 5D is a diagram illustrating a manufacturing step of a compound semiconductor device according to a third embodiment of the present invention;
Fig. 5E is a diagram illustrating a manufacturing step of a compound semiconductor device according to a third embodiment of the present invention;
Fig. 5F is a diagram illustrating a manufacturing step of a compound semiconductor device according to a third embodiment of the present invention;
Fig. 6 is a graph for illustrating an effect of the present invention;
Fig. 7A is a diagram illustrating a variation of a forming step of a source electrode and a drain electrode; and
Fig. 7B is a diagram illustrating a variation of a forming step of a source electrode and a drain electrode.

### EXPLANATION OF REFERENCE SIGNS

- 1: compound semiconductor device
- 11: substrate
- 12: GaN layer (electron transport layer)
- 13: AlGaN barrier layer
- 13a: unintentionally doped AlGaN layer
- 13b: n-AlGaN layer (electron supplying layer)
- 14: n-GaN layer
- 15, 26: TaSiO (first insulating film)
- 16, 27: Ta₂O₅ (second insulating film)
- 17: gate insulating film
- 18, 28: gate electrode
- 19: source electrode
- 20: drain electrode

### BEST MODE FOR CARRYING OUT THE INVENTION

Preferred embodiments of the present invention will be explained with reference to accompanying drawings.

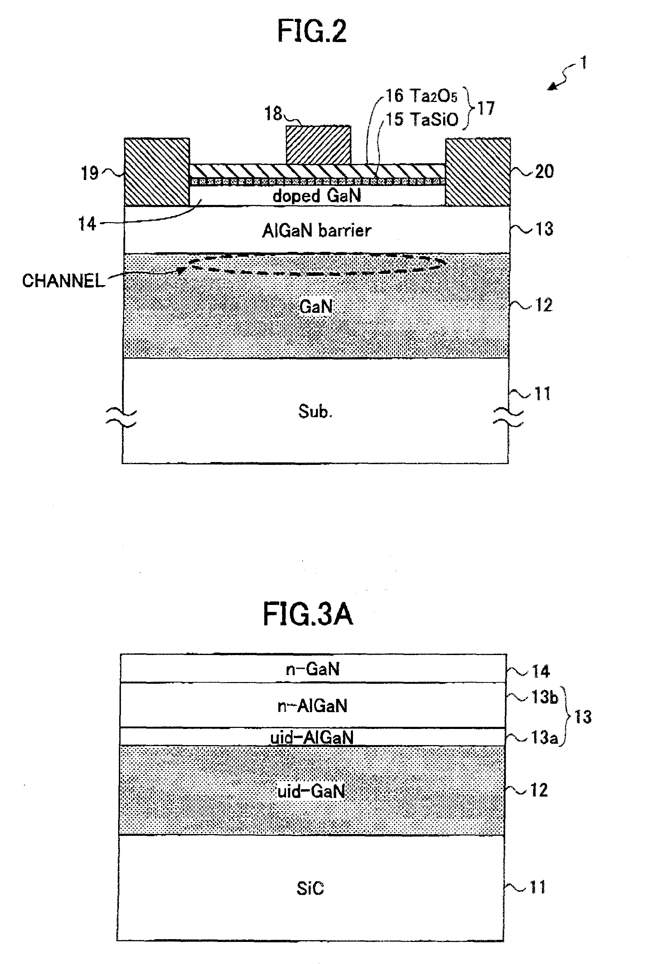

Fig. 2 is a schematic cross-sectional view of a compound semiconductor device according to an embodiment of the present invention. The compound semiconductor device 1 has a gallium nitride (GaN) electron transport layer 12 (III-V nitride compound semiconductor), an AlGaN barrier layer 13 and a dope GaN layer 14 formed on a substrate 11. A part of the AlGaN barrier layer 13 functions as an electron supplying layer.

Owing to the difference of band gap between the AlGaN barrier layer and the GaN electron transport layer 12, an electron layer (two-dimensional electron gas) generated at an interface between said layers operates at a high mobility and forms a channel.

A gate electrode 18 is positioned above the dope GaN layer 14 via a gate insulating film 17 having a two layer configuration. The gate insulating film 17 includes a first insulating film 15 and a second insulating film 16 formed on the first insulating film 15. The first insulating film 15 is a metal oxide including: oxygen; at least one element (first metal element) selected from a metal exhibiting a dielectric constant no less than 10 when combined with the oxygen; and another metal element (second metal element) selected from Si or Al. The first metal element is for increasing dielectric constant, and the second metal element is for widening the band gap. In the example of Fig. 2, Ta is used as the first metal element and Si is used as the second metal element. Accordingly, the first insulating film 15 is TaSiO. The second insulating film 16 is a metal oxide having a dielectric constant no less than 10. In the example of Fig. 2, the second insulating film 16 is Ta₂O₅.

Since the second insulating film 16 is for increasing the overall dielectric constant of the gate insulating film 17, the presence of the second insulating film 16 is preferable. However, in a case where the composition of the first insulating film enables a sufficient dielectric constant and a band gap to be attained for suitable operation, the first insulating film 15 may be used alone. Although the second insulating film 16 is needed for improving voltage resistance of the gate insulating film 17 (in other words, corresponding to gaining of film thickness of the first insulating film 15 + the second insulating film 16), the overall dielectric constant decreases where the dielectric constant of the second insulating film 16 is low. Therefore, it is preferable that the dielectric constant of the second insulating film 16 to be high.

Because at least a portion of the gate insulating film 17 includes the first metal element for improving dielectric constant and an oxide containing the second metal element for improving band gap, an insulating gate structure having both high dielectric constant and a wide band gap can be realized.

In the example of Fig. 2, although the first insulating film 15 having high dielectric constant and a wide band gap covers a wide area extending between a source electrode 19 and a drain electrode 20, the first insulating film 15 is to be positioned at least immediately below the gate electrode 18.

Next, a manufacturing method of a compound semiconductor device having the insulating gate structure described with Fig. 2 is described.

Figs. 3A-3F are diagrams illustrating steps of manufacturing a compound semiconductor device according to a first embodiment of the present invention. First, as illustrated in Fig. 3A, an unintentionally doped GaN electron transport layer (uid-GaN) 12 having a film thickness of, for example, 3 µm, an unintentionally doped Al_{0.25}Ga_{0.75}N layer (uid-AlGaN) 13a having a thickness of 3 nm, and a n-Al_{0.25}Ga_{0.75}N electron supplying layer having a thickness of 20 nm are sequentially deposited on a SiC substrate 11 by using a MOVPE method. For example, as an n-type dopant of the electron supplying layer 13b, silicon (Si) is doped with a doping density of 2 × 10¹⁸ cm⁻³. The unintentionally doped AlGaN layer 13a and the n-AlGaN electron supplying layer 13b form the AlGaN buffer layer 13. A n-GaN layer 14 having a film thickness no greater than 10 nm (e.g., 5 nm) is further deposited on the AlGaN buffer layer 13. For example, as an n-type dopant of the n-GaN layer 14, silicon (Si) is doped with a doping density of 2 × 10¹⁸ cm⁻³.

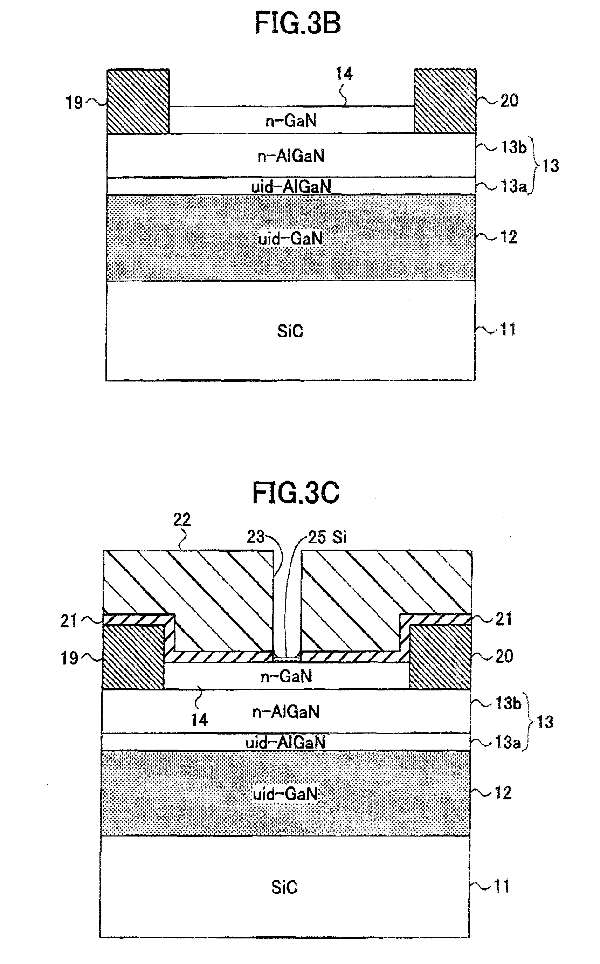

Then, as illustrated in Fig. 3B, the n-GaN layer 14 has its entire surface coated with resist (not illustrated), has apertures formed at portions at which the source electrode 19 and the drain electrode 20 are to be formed, and has corresponding regions reduced to a predetermined film thickness. In the example of Fig. 3B, all corresponding regions in the n-GaN layers 14 are removed. The processing of the n-GaN layer 14 is performed by a dry-etching method using chlorine gas or inert gas (e.g., Cl₂ gas). Then, the source electrode 19 and the drain electrode 20 are formed with Ti/Al by using an evaporation lift-off method and annealing at a temperature of 550 °C, to thereby form ohmic electrodes.

Then, as illustrated in Fig. 3C, after a passivation film (e.g., Si₃N₄ film) 21 is deposited on the entire surface of the wafer, the entire surface of the wafer is coated with resist 22 and apertures 23 having a width of, for example, 0.8 µm are formed at regions where a gate is formed. The gate region of the Si₃N₄ passivation film 21 is removed by, for example, dry-etching in fluorinated gas with use of a pattern formed by the apertures 23. After the removal, a Si film 25 is formed at the removed portion of the interface of the n-GaN film 14. Alternatively, after the removal of the passivation film 21, the resist 22 may be removed so that the Si film 25 can be formed on the entire surface.

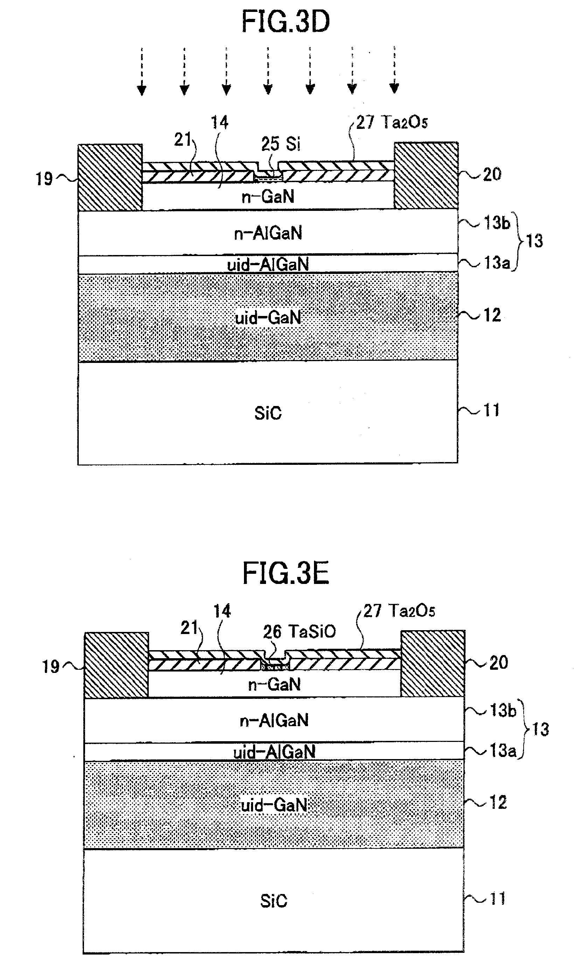

Then, as illustrated in Fig. 3D, a metal oxide layer (e.g., Ta₂O₅) 27 having a dielectric constant of no less than 10 is deposited on the entire surface of the wafer and is thermally processed in a range of 200 °C to 900 °C. By this thermal processing, as illustrated in Fig. 3E, the Si layer 25, which is located at the region where the gate is formed on the n-GaN layer interface, changes into a TaSiO layer 26. For the sake of convenience, the passivation film 21 and the Ta₂O₅ film 27 formed on the source electrode 19 and the drain electrode 20 are omitted in Fig. 3D and drawings thereafter.

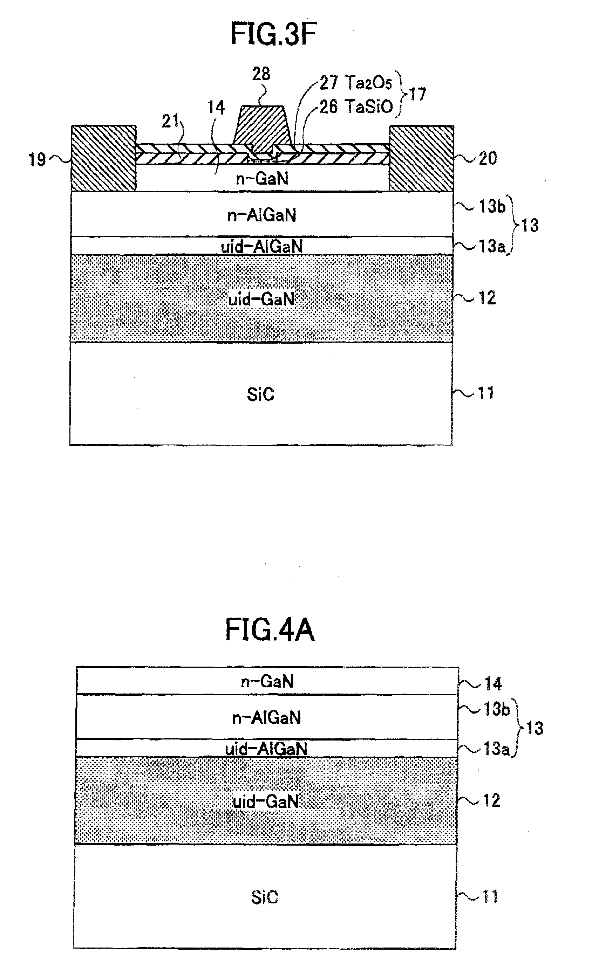

Then, as illustrated in Fig. 3F, a gate electrode 28 is formed by coating the entire surface with resist (not illustrated), patterning the resist to form an aperture having a width of, for example, 1.2 µm at the region where the gate is formed, sequentially depositing Ni (30 nm) and Au (300 nm) on the region, and performing a lift-off process on the deposited region. Thereby, GaN FET (compound semiconductor device) according to the first embodiment is manufactured.

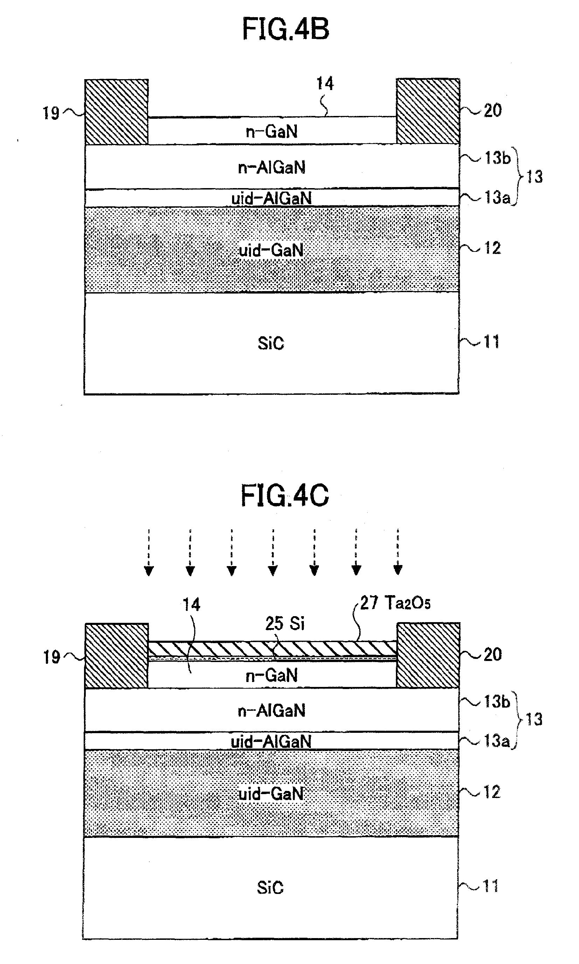

Figs. 4A-4E are diagrams illustrating steps of manufacturing a compound semiconductor device according to a second embodiment of the present invention. The steps performed until the source electrode 19 and the drain electrode 20 are formed are the same, that is, Figs. 4A and 4B are the same as Figs. 3A and 3B of the first embodiment and are not further described.

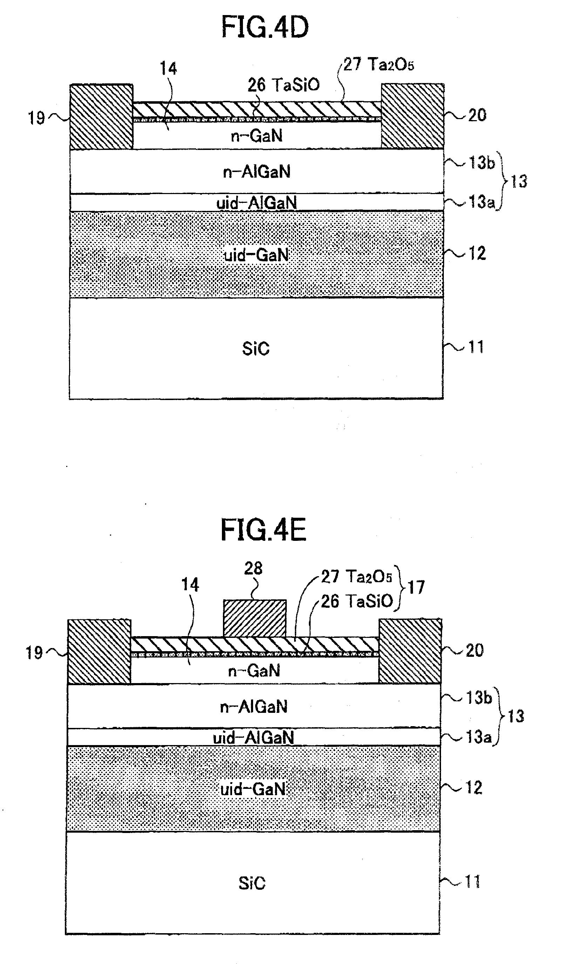

As illustrated in Fig. 4C, a Si film 25 is formed on the entire surface of a wafer by, for example, an evaporation method or a sputtering method. Then, a metal oxide layer (e.g., Ta₂O₅) having a dielectric constant of no less than 10 is deposited on the entire surface. Then, a thermal process is performed thereon in a range of 200 °C to 900 °C. As a result, a TaSiO layer 26 is formed at an interface of the n-GaN layer 14 as illustrated in Fig. 4D.

Then, as illustrated in Fig. 4E, resist (not illustrated) is formed on the entire surface and patterned to form an aperture having a width of, for example, 1.2 µm at the region where the gate is formed. Using the patterned resist as the mask, Ni (30 nm) and Au (300 nm) are sequentially deposited and subject to a lift-off process, to thereby form the gate electrode 28. Accordingly, a GaN FET according to the second embodiment is completed.

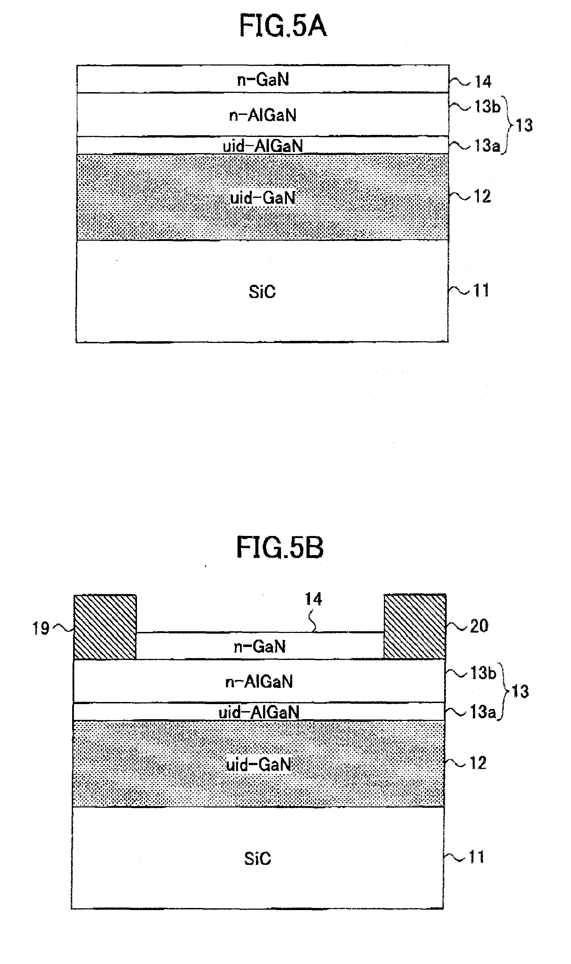

Figs. 5A-5F are diagrams illustrating steps of manufacturing a compound semiconductor device according to a third embodiment of the present invention. The steps performed until the source electrode 19 and the drain electrode 20 are formed are the same, that is, Figs. 5A and 5B are the same as Figs. 3A and 3B of the first embodiment and are not further described.

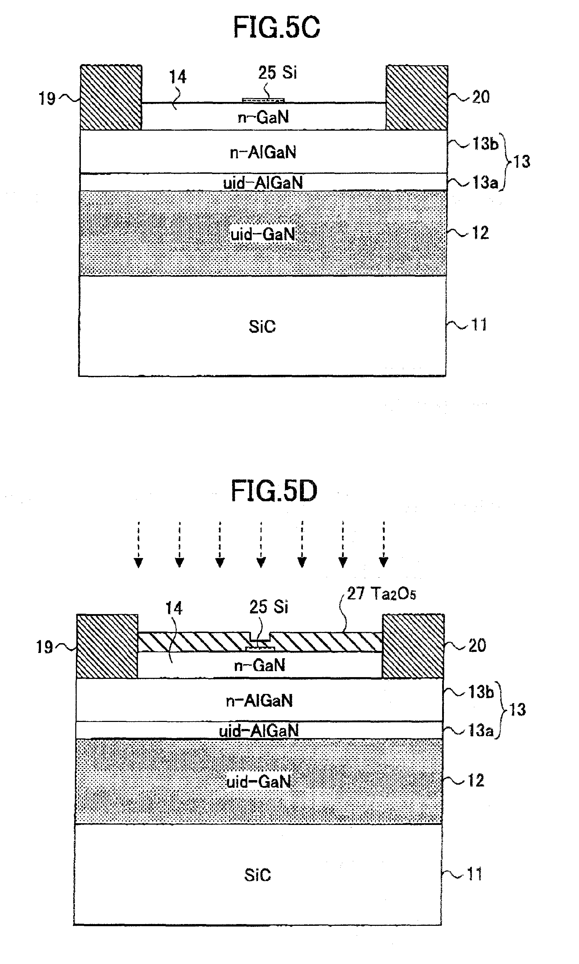

As illustrated in Fig. 5C, resist (not illustrated) is formed on the entire surface and an aperture having a width of, for example, 0.8 µm is formed at the region where the gate is formed, to thereby expose a corresponding area of the n-GaN layer 14. By depositing Si inside the aperture with an evaporation method or a sputtering method and performing a lift-off process thereon, a Si film 25 is formed at a predetermined region.

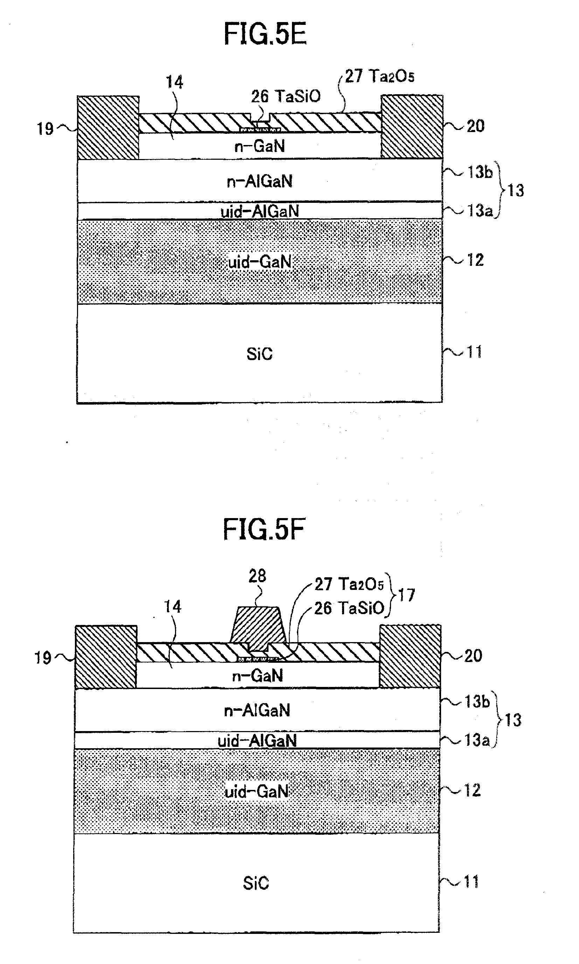

Then, as illustrated in Fig. 5D, a metal oxide layer (e.g., Ta₂O₅ layer) 27 having a dielectric constant of no less than 10 is deposited on the entire surface and flattened, so that a portion corresponding to the Si film 25 is formed into a shallow recess-like manner. In such a state, a thermal process is performed in a range of 200 °C to 900 °C. As a result, a TaSiO layer 26 is formed at the region where the gate is formed on the n-GaN layer interface as illustrated in Fig. 5E.

Then, as illustrated in Fig. 5F, resist is coated on the entire surface and is patterned having an aperture with a width of, for example, 1.2 µm at the region where the gate is formed, to thereby expose a corresponding area of the n-GaN layer 14. A gate electrode 28 is formed by depositing Ni (30 nm)/Au (300 nm) on the exposed n-GaN layer 14 and performing a lift-off process thereon. Accordingly, a GaN FET according to the third embodiment is completed.

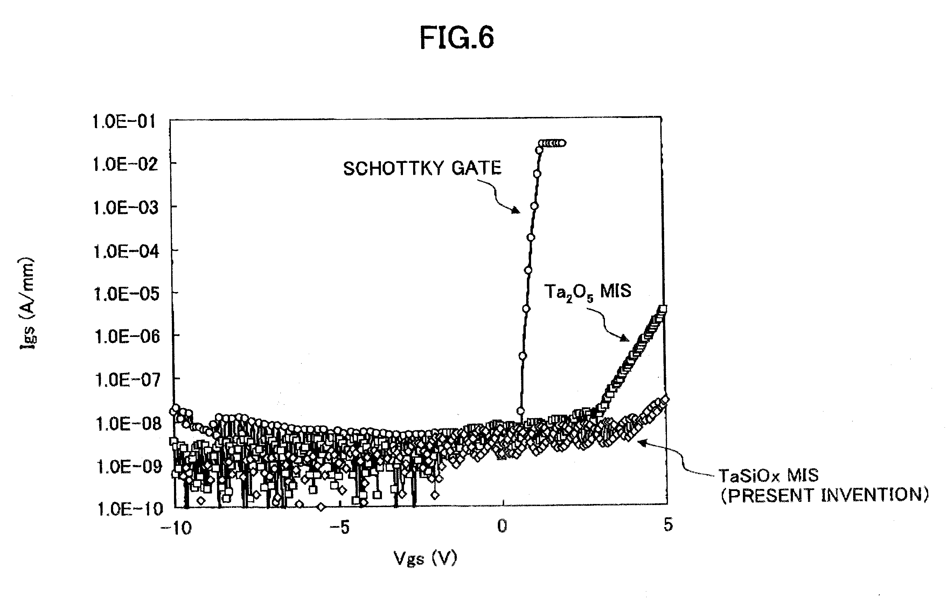

Fig. 6 is a graph illustrating an effect according to an embodiment of the present invention. The horizontal axis indicates voltage (V) applied to a gate, and the vertical axis indicates a gate leak current (A/mm). The plot of the white circles represents a gate leak current in a forward direction in a case where a gate electrode is directly formed on the III-V compound substrate layer. The plot of squares represents a gate leak current of a MISFET having the Ta₂O₅ insulating film illustrated in Fig. 1B inserted thereto. The plot of rhombuses represents a gate leak current of an FET using TaSiOx as its insulating gate structure according to the above-described embodiment of the present invention.

In comparison with the Schottky gate or the case where the Ta₂O₅ insulating film is inserted, it is apparent from the graph that the insulating gate structure of this embodiment exhibits a high voltage resistance characteristic with respect to voltage applied in a forward direction. Furthermore, a high dielectric constant can be obtained since this embodiment includes a metal element forming a metal oxide having a relatively high dielectric constant (e.g., no less than 10).

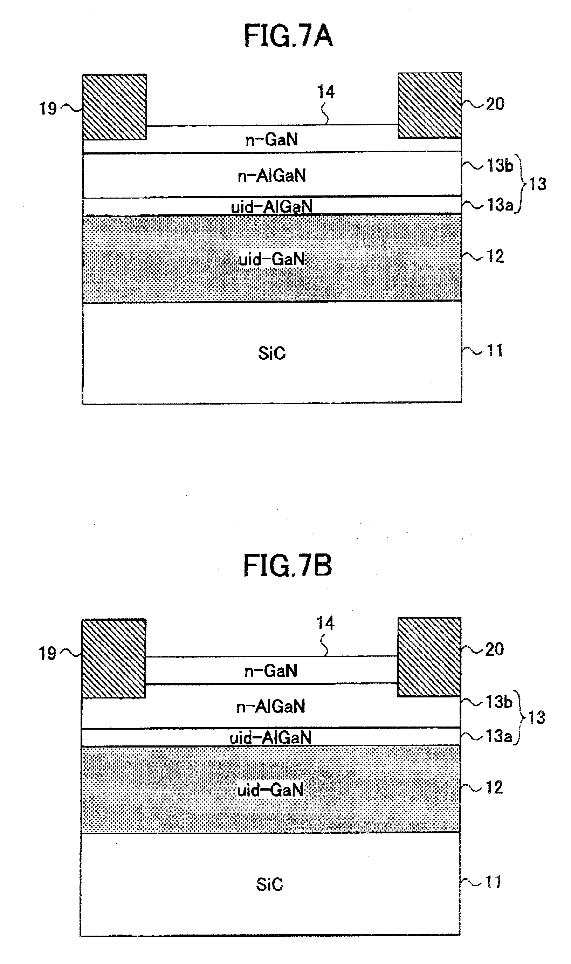

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a illustrating of the superiority or inferiority of the invention. Although the embodiments of the present invention have been described in detail, it can understand that various changes, substitutions, and alterations could be made hereto without departing from the spirit and scope of the invention. For example, in Figs. 3B, 4B, and 5B, the n-GaN layer 14 formed in the regions where the source electrode 19 and the drain electrode 20 are formed do not need to be entirely removed. The n-GaN layer 14 may remain at areas corresponding to the source electrode 19 and the drain electrode 20 by being thinly formed as illustrated in Fig. 7A. Further, the n-AlGaN electron supplying layer 13b may be thinly formed at areas corresponding to the source electrode 19 and the drain electrode 20 as illustrated in Fig. 7B. In either case, a compound semiconductor device having an insulating gate structure of high voltage resistance and high dielectric constant can be realized.

## Claims

1. A compound semiconductor device comprising:
an electron transport layer that is formed on a substrate and includes a III-V nitride compound semiconductor;
a gate insulating film that is positioned above the compound semiconductor layer; and
a gate electrode that is positioned on the gate insulating film; **characterized in that**
the gate insulating film includes
a first insulating film that includes oxygen,
at least a single metal element selected from a metal bonding with the oxygen and forming a metal oxide having a dielectric constant no less than 10, and
at least a single metal element selected from Si and Al.

2. The compound semiconductor device as claimed in claim 1, **characterized in that** the gate insulating film further includes a second insulating film that is positioned on the first insulating film and includes a metal oxide having a dielectric constant no less than 10.

3. The compound semiconductor device as claimed in claim 1, **characterized by** further comprising:
an electron supplying layer of the III-V nitride compound semiconductor provided on the electron transport layer;
a III-V nitride compound semiconductor layer that is provided between the electron supplying layer and the gate insulating film and doped with impurities having a predetermined density.

4. The compound semiconductor device as claimed in claim 1, **characterized in that** the electron transport layer is a GaN layer, and further comprises:
a AlₓGa₁₋ₓN (0 ≦ x ≦ 1) electron supplying layer that is provided on the GaN electron transport layer and doped with impurities having a predetermined density; and
a GaN layer that is provided between the AlₓGa₁₋ₓN (0 ≦ x ≦ 1) electron supplying layer and the gate insulating film and doped with impurities having a predetermined density.

5. The compound semiconductor device as claimed in claim 4, **characterized by** further comprising:
a source electrode and a drain electrode positioned above the electron transport layer and one on each side of the gate electrode;
wherein the doped GaN layer is thin at areas where the source electrode and the drain electrode are provided.

6. The compound semiconductor device as claimed in claim 4, **characterized by** further comprising:
a source electrode and a drain electrode provided above the electron transport layer and on both sides of the gate electrode;
wherein the doped GaN layer is completely removed at areas where the source electrode and the drain electrode are provided.

7. The compound semiconductor device as claimed in claim 4, **characterized by** further comprising:
a source electrode and a drain electrode provided above the electron transport layer and on both sides of the gate electrode;
wherein the doped GaN layer is completely removed at areas where the source electrode and the drain electrode are provided;
wherein the AlGaN electron supplying layer is than at the areas.

8. The compound semiconductor device as claimed in claim 4, **characterized in that** the doped GaN film is doped with an n type no less than 1 × 10¹⁷ cm⁻³.

9. A manufacturing method of a compound semiconductor device **characterized by** comprising the steps of:
forming an electron transport layer including a III-V nitride compound semiconductor on a substrate;
forming a first insulating film including oxygen, at least a single metal element selected from a metal bonding with the oxygen and forming a metal oxide having a dielectric constant no less than 10, and at least a single metal element selected from Si and Al, above the electron transport layer; and
forming a gate electrode above the first insulating film;

10. The manufacturing method as claimed in claim 9, **characterized by** further comprising a step of:
forming a second insulating film including a metal oxide having a dielectric constant no less than 10, on the first insulating film before forming the gate electrode.

11. The manufacturing method as claimed in claim 9, **characterized in that** the first insulating film is formed by
depositing a silicon film on the electron transport layer,
forming a layer of a metal oxide having a dielectric constant no less than 10, on the silicon film, and
annealing the silicon film and the layer of the metal oxide.

12. The manufacturing method as claimed in claim 11, **characterized in that** at least a portion of the silicon film is changed into the first insulating film by the annealing step.

13. The manufacturing method as claimed in claim 9, **characterized by** further comprising the steps of:
forming an electron supplying layer of a III-V nitride compound semiconductor on the electron transport layer, and
forming a III-V nitride compound semiconductor layer having impurities doped with a predetermined density, on the electron supplying layer,
wherein the first insulating film is formed on the doped III-V nitride compound semiconductor layer.

14. The manufacturing method as claimed in claim 9, **characterized by** further comprising the steps of:
forming the electron transport layer as a GaN layer;
forming a AlₓGa₁₋ₓN (0 ≦ x ≦ 1) electron supplying layer doped with impurities having a predetermined density, on the GaN electron transport layer; and
forming a GaN layer doped with impurities having a predetermined density, on the AlₓGa₁₋ₓN (0 ≦ x ≦ 1) electron supplying layer;
wherein the first insulating film is formed on the GaN layer.
